# EUROPEAN PATENT SPECIFICATION

(11) **EP 3 664 147 B1**
(45) Date of publication and mention of the grant of the patent: **31.01.2024**
(21) Application number: 19213960.8
(22) Date of filing: 05.12.2019
(51) Int. Cl.: H10K 59/80, H10K 59/122, H10K 59/35

(54) **ELECTROLUMINESCENT DISPLAY DEVICE**
ELEKTROLUMINESZENTE ANZEIGEVORRICHTUNG
DISPOSITIF D'AFFICHAGE ÉLECTROLUMINESCENT

(30) Priority: 07.12.2018 KR 20180156567
(43) Date of publication of application: 10.06.2020
(73) Proprietor: LG Display Co., Ltd., Seoul 07336 (KR)
(72) Inventor: LIM, Hyeongjun, Paju-si Gyeonggi-do 10845 (KR); YOUN, Wooram, Paju-si Gyeonggi-do 10845 (KR); KIM, Minki, Paju-si Gyeonggi-do 10845 (KR)
(74) Representative: Wellburn, Daniel

(56) References cited:
- EP-A1- 3 343 662
- EP-A2- 1 930 968
- WO-A1-2018/021196
- DE-A1-102020 121 091
- GB-A- 2 590 753
- KR-A- 20120 004 163
- US-A1- 2008 296 600
- US-A1- 2014 103 385
- US-A1- 2016 043 161
- US-A1- 2016 293 888
- US-A1- 2018 122 868

## Description

This application claims the benefit of the Korean Patent Application No.10-2018-0156567 filed on December 07, 2018.

### BACKGROUND

### Field

The present disclosure relates to an electroluminescent display device.

### Discussion of Related Art

An electroluminescent display device is provided in such a way that an emission layer is provided between an anode electrode and a cathode electrode, and the emission layer emits light by an electric field generated between the above two electrodes, to thereby display an image.

The emission layer may be formed of an organic material which emits light when exciton is produced by a bond of electron and hole, and the exciton falls to a ground state from an excited state, or may be formed of an inorganic material such as quantum dot.

In case of the related art, the anode electrode is formed of a reflective electrode, and the cathode electrode is formed of a semi-transmissive electrode, whereby a micro-cavity effect is obtained by repetitive reflection and re-reflection of the light between the anode electrode and the cathode electrode.

However, in order to obtain the micro-cavity effect, a distance between the anode electrode and the cathode electrode, that is, a thickness of the emission layer has to be optimized. In this case, it has limitations on providing an organic emitting layer for emitting predetermined colored light at a position enabling to optimize a charge balance in the emission layer.

That is, in case of the related art, it is difficult to optimize both of the micro-cavity effect and the charge balance. US 2018/122868 A1 discloses an organic light emitting display device includes a substrate; first and second organic light emitting diodes laterally shifted with respect to each other on the substrate; an encapsulation layer covering the first and second organic light emitting diodes, the encapsulation layer including a plurality of layers; and a first color filter and a second color filter each within the plurality of layers, the first color filter and the second color filter being respectively disposed over respective ones of the first and second organic light emitting diodes at respectively different heights from the substrate.
EP 1 930 968 A2 discloses an organic light emitting display apparatus that can increase contrast of the organic light emitting display apparatus. The organic light emitting display apparatus includes; a substrate; an organic light emitting device disposed on the substrate to display an image; a sealing member formed on the organic light emitting device; a semitransparent film formed on an upper surface of the sealing member facing the outside to transmit a portion of external light and to reflect another portion of external light; a passivation film formed on the semitransparent film in order to protect the semitransparent film by covering the semitransparent film; and a transmissive black layer formed between the sealing member and the organic light emitting device in order to increase contrast, wherein the semitransparent film has a refractive index greater than that of the passivation film.
US 2008/296600 A1 discloses an organic light emitting display includes a substrate, an OLED including an anode electrode, a cathode electrode and an organic thin film formed between the anode electrode and the cathode electrode, a reflective layer on the OLED, the reflective layer comprising a laminated first material and second material, the first material and the second material having different refractive indices, and an encapsulation layer on the reflective layer, the encapsulation layer comprising at least one of organic thin film and inorganic thin film.
US 2016/043161 A1 discloses an organic electroluminescence display device including pixels, a first bank provided between the pixels and covering a periphery edge part of a pixel electrode, a second bank provided on a first upper surface of the first bank and including a second upper surface and a first side surface, an auxiliary wiring provided on the second upper surface and including a third upper surface and a second side surface, an organic electroluminescence layer in contact with the pixel electrode, the first and second banks, and the auxiliary wiring, a common pixel electrode bridging the pixels, the organic electroluminescence layer includes a first region in contact with the pixel electrode, the first upper surface and the first side surface, and a second region in contact with the auxiliary wiring and separated from the first region, and the common pixel electrode is in contact with the second side surface.
KR 2012 0004163 A discloses a three stage for the dipping with excellent elasticity which wraps the wadding manufactured with the polyester short staple on the core which makes and in which two kinds of material is quilted with the cloth for the cover and which is manufactured and resilience to the polymer material having elasticity including the polyurethane or the rubber latex etc. and the providing is to the purpose.
US 2016/0293888 A1 discloses a display device including a pixel area and a contact area. Within the pixel area, an anode is electrically coupled to a source or a drain of a thin film transistor through a pacification layer. An organic light emitting layer is formed on the anode, and the cathode is formed on the organic light-emitting layer. Within the contact area. an auxiliary contact hole is formed in the pacification layer, the auxiliary contact hole formed to have an inverse tapered shape. An auxiliary line has a first portion formed over the pacification layer and a second portion formed in the auxiliary contact hole. A portion of the cathode physically contacts the second portion of the auxiliary line within the auxiliary contact hole.
US 2014/103385 A1 discloses a light-emitting device including lower electrodes over an insulating layer; a partition over a portion between the lower electrodes, which includes an overhang portion over an end portion of each of the lower electrodes; a first light-emitting unit over each of the lower electrodes and the partition; an intermediate layer over the first light-emitting unit; a second light-emitting unit over the intermediate layer; and an upper electrode over the second light-emitting unit. The distance between the overhang portion and each of the lower electrodes is larger than the total thickness of the first light-emitting unit and the intermediate layer over the lower electrode.

### SUMMARY

Accordingly, the present disclosure is directed to providing an electroluminescent display device that substantially obviates one or more problems due to limitations and disadvantages of the related art.

An aspect of the present disclosure is directed to providing an electroluminescent display device which is capable of optimizing both of a micro-cavity effect and a charge balance.

Additional advantages and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

An invention is defined in the appended independent claim.

According to one embodiment of the present disclosure, the micro-cavity effect may be obtained by repetitive reflection and re-reflection between the reflective electrode of the first electrode and the semi-transmissive layer on the second electrode, whereby it is possible to obtain the micro-cavity effect by appropriately adjusting a thickness of the emission layer provided between the first electrode and the second electrode, a thickness of the second electrode, and a thickness of the encapsulation layer provided between the second electrode and the semi-transmissive layer. The micro-cavity effect may be obtained by adjusting the thickness of the second electrode and the thickness of the encapsulation layer in addition to the thickness of the emission layer. Thus, it facilitates providing the organic emitting layer configured to emit predetermined colored light at an optimal position enabling to optimize the charge balance in the emission layer.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a schematic cross sectional view illustrating an electroluminescent display device according to one embodiment not forming part of the claimed invention;
FIG. 2 is a schematic cross sectional view illustrating an electroluminescent display device according to another embodiment not forming part of the claimed invention;
FIG. 3 is a schematic cross sectional view illustrating an electroluminescent display device according to another embodiment not forming part of the claimed invention;
FIG. 4 is a schematic cross sectional view illustrating an electroluminescent display device according to another embodiment not forming part of the claimed invention;
FIG. 5 is a schematic cross sectional view illustrating an electroluminescent display device according to another embodiment not forming part of the claimed invention;
FIG. 6 is a schematic cross sectional view illustrating an electroluminescent display device according to another embodiment of the present disclosure; and
FIGs. 7A to 7C illustrate an electroluminescent display device according to another embodiment of the present disclosure, which relate to a head mounted display (HMD) device.

### DETAILED DESCRIPTION OF THE DISCLOSURE

Reference will now be made in detail to the exemplary embodiments of the present disclosure, examples of which are illustrated in the accompanying drawings. Wherever possible, the same reference numbers will be used throughout the drawings to refer to the same or like parts.

Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art. Further, the present invention is only defined by scopes of appended claims.

A shape, a size, a ratio, an angle, and a number disclosed in the drawings for describing embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In construing an element, the element is construed as including an error range although there is no explicit description.

In describing a position relationship, for example, when a position relation between two parts is described as 'on~', 'over~', 'under~', and 'next~', one or more other parts may be disposed between the two parts unless 'just' or 'direct' is used.

In describing a time relationship, for example, when the temporal order is described as 'after~', 'subsequent~', 'next~', and 'before~', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present invention, which is defined in the appended set of claims.

Features of various embodiments of the present disclosure may be partially or overall coupled to or combined with each other, and may be variously inter-operated with each other and driven technically as those skilled in the art can sufficiently understand. The embodiments of the present disclosure may be carried out independently from each other, or may be carried out together in co-dependent relationship.

Hereinafter, exemplary embodiments of the present disclosure will be described in detail with reference to the accompanying drawings.

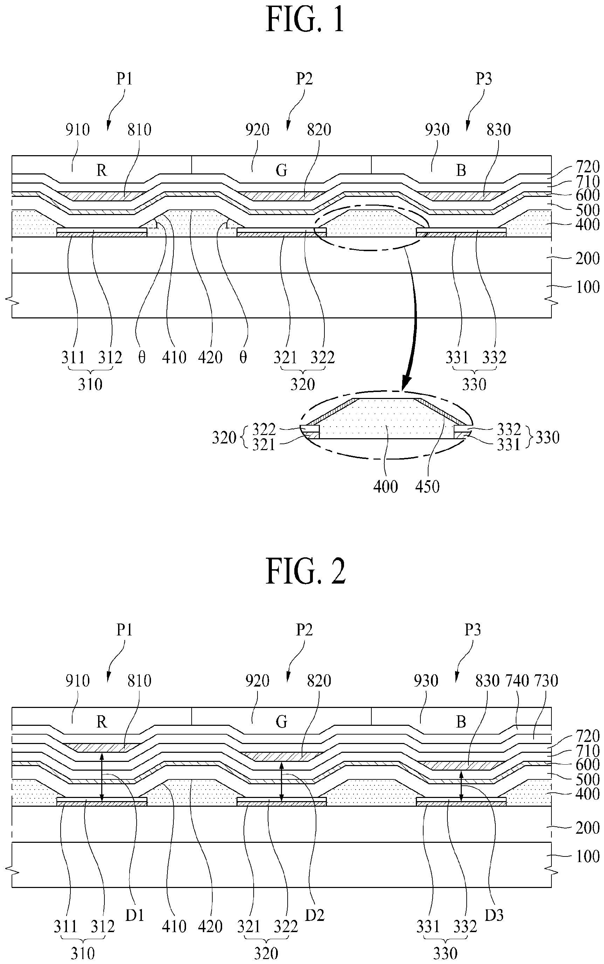

FIG. 1 is a schematic cross-sectional view illustrating an electroluminescent display device according to one embodiment of the present disclosure.

As shown in FIG. 1, the electroluminescent display device according to one embodiment, which does not form part of the claimed invention, includes a substrate 100, a circuit device layer 200, a first electrode 310, 320 and 330, a bank 400, an emission layer 500, a second electrode 600, an encapsulation layer 710 and 720, a semi-transmissive layer 810, 820 and 830, and a color filter layer 910, 920 and 930.

The substrate 100 may be formed of glass or plastic, but not limited to these materials. The substrate 100 may be formed of a semiconductor material such as a silicon wafer. The substrate 100 may be formed of a transparent material or an opaque material. On the substrate 100, there are a first sub pixel (P1), a second sub pixel (P2), and a third sub pixel (P3). The first sub pixel (P1) emits red (R) colored light, the second sub pixel (P2) emits green (G) colored light, and the third sub pixel (P3) emits blue (B) colored light, but not limited to this structure. For example, an arrangement order of the respective sub pixels (P1, P2, P3) may be changed in various ways.

The electroluminescent display device according to one embodiment of the present disclosure may be formed in a top emission type where emitted light advances upwardly, but not limited to this type. If the electroluminescent display device is formed in the top emission type, the first substrate 100 may be formed of an opaque material as well as a transparent material.

The circuit device layer 200 is provided on the substrate 100.

In the circuit device layer 200, a circuit device comprising various signal lines, thin film transistors and a capacitor is provided by each sub pixel (P1, P2, P3). The signal lines may include a gate line, a data line, a power line and a reference line, and the thin film transistors may include a switching thin film transistor, a driving thin film transistor and a sensing thin film transistor.

The switching thin film transistor is switched by a gate signal supplied to the gate line, and the switching thin film transistor supplies a data voltage, which is supplied from the data line, to the driving thin film transistor.

The driving thin film transistor is switched by the data voltage supplied from the switching thin film transistor, and the driving thin film transistor generates a data current from power source supplied from the power line, and supplies the data current to the first electrode 310, 320 and 330.

The sensing thin film transistor senses a deviation of threshold voltage in the driving thin film transistor, which causes a deterioration of picture quality. The sensing thin film transistor supplies a current of the driving thin film transistor to the reference line in response to a sensing control signal supplied from the gate line or an additional sensing line.

The capacitor maintains the data voltage supplied to the driving thin film transistor for one frame period, and the capacitor is connected with each of gate and source terminals of the driving thin film transistor.

The first electrode 310, 320 and 330 is connected with the driving thin film transistor provided in the circuit device layer 200. In detail, the first electrode 310, 320 and 330 is connected with the source terminal or drain terminal of the driving thin film transistor through a contact hole provided in the circuit device layer 200.

The first electrode 310, 320 and 330 may be patterned by each sub pixel (P1, P2, P3) on the circuit device layer 200. One of the first electrode 310 is formed in the first sub pixel (P1), another first electrode 320 is formed in the second sub pixel (P2), and another first electrode 330 is formed in the third sub pixel (P3).

The first electrode 310 of the first sub pixel (P1) includes a first reflective electrode 311 and a first transparent electrode 312. The first transparent electrode 312 is provided on an upper surface of the first reflective electrode 311, whereby the first reflective electrode 311 and the first transparent electrode 312 are electrically connected with each other. The first reflective electrode 311 upwardly reflects light emitted from the emission layer 500 of the first sub pixel (P1), and the first transparent electrode 312 may function as an anode for generating a hole in the first sub pixel (P1).

The first electrode 320 of the second sub pixel (P2) includes a second reflective electrode 321 and a second transparent electrode 322. The second transparent electrode 322 is provided on an upper surface of the second reflective electrode 321, whereby the second reflective electrode 321 and the second transparent electrode 322 are electrically connected with each other. The second reflective electrode 321 upwardly reflects light emitted from the emission layer 500 of the second sub pixel (P2), and the second transparent electrode 322 may function as an anode for generating a hole in the second sub pixel (P2).

The first electrode 330 of the third sub pixel (P3) includes a third reflective electrode 331 and a third transparent electrode 332. The third transparent electrode 332 is provided on an upper surface of the third reflective electrode 331, whereby the third reflective electrode 331 and the third transparent electrode 332 are electrically connected with each other. The third reflective electrode 331 upwardly reflects light emitted from the emission layer 500 of the third sub pixel (P3), and the third transparent electrode 332 may function as an anode for generating a hole in the third sub pixel (P3).

The bank 400 is configured to cover the end of the first electrode 310, 320 and 330 on the circuit device layer 200. Accordingly, it is possible to prevent a current from being concentrated into the end of the first electrode 310, 320 and 330, to thereby prevent a deterioration of an emission efficiency.

The bank 400 is formed as a matrix configuration in the boundary between each of the plurality of sub pixels (P1, P2, P3), and is configured to define an emission area in each individual sub pixel (P1, P2, P3). That is, an exposed area of the first electrode 310, 320 and 330, which is exposed without being covered by the bank 400 in each sub pixel (P1, P2, P3), becomes the emission area.

The bank 400 includes a lateral surface 410 being in contact with each sub pixel (P1, P2, P3), and an upper surface 420 extending from the lateral surface 410. In this case, the bank 400 is provided in such a way that the lateral surface 410 is inclined at a predetermined angle (θ) with respect to an upper surface of the substrate 100 and the light emitted from the emission layer 500 of each sub pixel (P1, P2, P3) is refracted on the lateral surface 410, whereby it is possible to prevent the light emitted from the emission layer 500 of each sub pixel (P1, P2, P3) from being mixed together between the neighboring sub pixels (P1, P2, P3).

In this case, a refractive index of the bank 400 is smaller than a refractive index of the emission layer 500 in order to make the light emitted from the emission layer 500 of each sub pixel (P1, P2, P3) be easily refracted on the lateral surface 410 of the bank 400, preferably. Also, an angle (θ) between the lateral surface 410 of the bank 400 and the upper surface of the substrate 100 is within a range from 30° to 80°, preferably.

Also, as shown in an expanded view of an arrow, a reflective layer 450 may be additionally provided in the lateral surface 410 of the bank 400. In this case, the light emitted from the emission layer 500 of each sub pixel (P1, P2, P3) is refracted on the reflective layer 450, and is prevented from being mixed with light of the neighboring sub pixel between the neighboring sub pixels (P1, P2, P3), thereby improving a luminance of the electroluminescent display device. Although not shown, the reflective layer 450 may extend to the upper surface 420 of the bank 400.

The emission layer 500 is formed on the first electrode 310, 320 and 330. The emission layer 500 is formed on the bank 400. That is, the emission layer 500 may be formed in each sub pixel (P1, P2, P3) and the boundary area between the sub pixels (P1, P2, P3).

The emission layer 500 may be configured to emit white (W) colored light. To this end, the emission layer 500 may include a plurality of stacks configured to emit different colored light.

For example, the emission layer 500 includes a first stack (1^{st} stack) configured to emit first colored light, a second stack (2^{nd} stack) configured to emit second colored light, and a charge generating layer (CGL) disposed between the first stack and the second stack. The first stack (1^{st} stack) may be formed in a deposition structure obtained by sequentially depositing a hole injecting layer, a hole transporting layer, a blue organic emitting layer, and an electron transporting layer, which are sequentially provided on the first electrode 310, 320 and 330, but not limited to this structure. The second stack (2^{nd} stack)may be formed in a deposition structure obtained by sequentially depositing a hole transporting layer, a yellow green organic emitting layer, an electron transporting layer, and an electron injecting layer, which are sequentially provided on the charge generating layer (CGL), but not limited to this structure.

If needed, the emission layer 500 may include a first stack (1^{st} stack) configured to emit blue colored light, a second stack (2^{nd} stack) configured to emit green colored light, a third stack (3^{rd} stack) configured to emit red colored light, a first charge generating layer disposed between the first stack and the second stack, and a second charge generating layer disposed between the second stack and the third stack.

The second electrode 600 is formed on the emission layer 500. The second electrode 600 may function as a cathode of the electroluminescent display device. In the same manner as the emission layer 500, the second electrode 600 may be formed in each sub pixel (P1, P2, P3), and the boundary area between the sub pixels (P1, P2, P3). That is, the second electrode 600 may be formed above the bank 400.

As the electroluminescent display device according to one embodiment of the present disclosure may be formed in the top emission type, the second electrode 600 may be formed of the transparent electrode which is capable of upwardly transmitting the light emitted from the emission layer 500.

The encapsulation layer 710 and 720 is formed on the second electrode 600, to thereby prevent external moisture from being permeated into the emission layer 500.

The encapsulation layer 710 and 720 includes a first encapsulation layer 710 formed on an upper surface of the second electrode 600, and a second encapsulation layer 720 formed on an upper surface of the first encapsulation layer 710. Each of the first encapsulation layer 710 and the second encapsulation layer 720 may be formed of an inorganic insulating material, but not necessarily. Each of the first encapsulation layer 710 and the second encapsulation layer 720 may be formed of an organic insulating material

The semi-transmissive layer 810, 820 and 830 is disposed between the first encapsulation layer 710 and the second encapsulation layer 720. In the area which is overlapped with the semi-transmissive layer 810, 820 and 830, an upper surface of the first encapsulation layer 710 is in contact with a lower surface of the semi-transmissive layer 810, 820 and 830, and a lower surface of the second encapsulation layer 720 is in contact with an upper surface of the semi-transmissive layer 810, 820 and 830. Also, in the area which is not overlapped with the semi-transmissive layer 810, 820 and 830, an upper surface of the first encapsulation layer 710 is in contact with a lower surface of the second encapsulation layer 720.

The semi-transmissive layer 810, 820 and 830 includes a first semi-transmissive layer 810 patterned in the first sub pixel (P1), a second semi-transmissive layer 820 patterned in the second sub pixel (P2), and a third semi-transmissive layer 830 patterned in the third sub pixel (P3). The first semi-transmissive layer 810 is overlapped with the first electrode 310 of the first sub pixel (P1), the second semi-transmissive layer 820 is overlapped with the first electrode 320 of the second sub pixel (P2), and the third semi-transmissive layer 830 is overlapped with the first electrode 330 of the third sub pixel (P3).

The semi-transmissive layer 810, 820 and 830 may be formed of a material capable of partially transmitting some of the incident light, and reflecting the remaining incident light (ignoring any small but negligible absorption of the incident light by the semi-transmissive layer). It may be understood that the semi-transmissive layer 810, 820 and 830 may be arranged to partially reflect light and partially transmit light, preferably in a wavelength range which includes the peak emission wavelength of the emission layer 500. Preferably, semi-transmissive layer 810, 820 and 830 may be arranged to partially reflect and partially transmit light in a wavelength range which includes the whole emission wavelength range of the emission layer 500.

The proportion of incident light transmitted by the semi-transmissive layer 810, 820 and 830 at the peak emission wavelength of the emission layer 500 may be 20-80%. The proportion of incident light reflected by the semi-transmissive layer 810, 820 and 830 at the peak emission wavelength of the emission layer 500 may be 20-80%. These transmittance and reflectance ranges may be correct for light incident normal to the interface between the semi-transmissive layer itself and the encapsulation layer beneath the semi-transmissive layer. The transmittance and reflectance of the semi-transmissive layer may be controlled by an appropriate combination of materials selected for the semi-transmissive layer and the encapsulation layer directly beneath the semi-transmissive layer.

The semi-transmissive layer 810, 820 and 830 may realize a micro-cavity effect by each individual sub pixel (P1, P2, P3). That is, the micro-cavity effect may be obtained by repetitive reflection and re-reflection of the light between the semi-transmissive layer 810, 820 and 830 and the reflective electrode 311, 321 and 331 of the first electrode 310, 320 and 330. In detail, the reflection and re-reflection of the light is repeated between the first semi-transmissive layer 810 and the first reflective electrode 311 in the first sub pixel (P1), the reflection and re-reflection of the light is repeated between the second semi-transmissive layer 820 and the second reflective electrode 321 in the second sub pixel (P2), and the reflection and re-reflection of the light is repeated between the third semi-transmissive layer 830 and the third reflective electrode 331 in the third sub pixel (P3).

Generally, in case of the related art, the second electrode 600 is formed of a semi-transmissive material, whereby the micro-cavity effect may be obtained by repetitive reflection and re-reflection of the light between the reflective electrode 311, 321 and 331 of the first electrode 310, 320 and 330 and the second electrode 600.

In this case, in order to obtain the micro-cavity effect, an interval between the second electrode 600 and the reflective electrode 311, 321 and 331 of the first electrode 310, 320 and 330 has to be adjusted appropriately. To this end, an entire thickness of the emission layer 500 has to be set appropriately. However, if the entire thickness of the emission layer 500 is set in consideration of only the micro-cavity effect, it has limitation on optimal position of the blue colored or yellow colored organic emitting layer in the emission layer 500 so as to optimize a charge balance for improvement of exciton formation efficiency.

Meanwhile, according to one embodiment of the present disclosure, the micro-cavity effect is obtained by repetitive reflection and re-reflection of the light between the semi-transmissive layer 810, 820 and 830 and the reflective electrode 311, 321 and 331 of the first electrode 310, 320 and 330. Thus, the micro-cavity effect may be obtained by appropriately setting a thickness of the first encapsulation layer 710 and a thickness of the second electrode 600 in addition to the entire thickness of the emission layer 500.

Thus, according to one embodiment of the present disclosure, the entire thickness of the emission layer 500 may be set to provide the blue colored or yellow green colored organic emitting layer in the emission layer 500 at the position capable of optimizing the charge balance and furthermore improving the exciton formation efficiency, and the thickness of the second electrode 600 and the thickness of the first encapsulation layer 710 may be optimally set for realizing the micro-cavity effect in consideration of the preset entire thickness of the emission layer 500.

As a result, in case of the related art, it is difficult to improve both the micro-cavity effect and the exit on formation efficiency. Meanwhile, according to one embodiment of the present disclosure, the semi-transmissive layer 810, 820 and 830 is additionally provided so that it is possible to improve both the micro-cavity effect and the exit on formation efficiency.

Meanwhile, the first semi-transmissive layer 810, the second semi-transmissive layer 820, and the third semi-transmissive layer 830 are provided at fixed intervals. Especially, the first semi-transmissive layer 810, the second semi-transmissive layer 820, and the third semi-transmissive layer 830 are apart from each other in the boundary area between the sub pixels (P1, P2, P3) being overlapped with the bank 400. That is, the first semi-transmissive layer 810, the second semi-transmissive layer 820, and the third semi-transmissive layer 830 are not formed in the boundary area between the sub pixels (P1, P2, P3).

Accordingly, the first semi-transmissive layer 810, the second semi-transmissive layer 820, and the third semi-transmissive layer 830 are apart from each other in the boundary area between the sub pixels (P1, P2, P3) so that it is possible to prevent the light emitted from the emission layer 500 of each sub pixel (P1, P2, P3) from being reflected on the boundary area between the sub pixels (P1, P2, P3) and being advanced to the neighboring sub pixel (P1, P2, P3), to thereby reduce a problem related with the mixture of colored light between the sub pixels (P1, P2, P3).

In order to prevent mixture of color between the sub pixels (P1, P2, P3), preferably, the first semi-transmissive layer 810, the second semi-transmissive layer 820, and the third semi-transmissive layer 830 are not overlapped with the upper surface 420 of the bank 400, but not necessarily. If the first semi-transmissive layer 810, the second semi-transmissive layer 820, and the third semi-transmissive layer 830 are not overlapped with the upper surface 420 of the bank 400, the upper surface of the first encapsulation layer 710 is in contact with the lower surface of the second encapsulation layer 720 in the area overlapped with the upper surface 420 of the bank 400.

The semi-transmissive layer 810, 820 and 830 is provided to realize the micro-cavity effect, and the semi-transmissive layer 810, 820 and 830 does not function as an electrode for a light emission of the emission layer 500. Thus, the semi-transmissive layer 810, 820 and 830 may be formed of a nonconductive material, but not necessarily. The semi-transmissive layer 810, 820 and 830 may be formed of a conductive material.

The color filter layer 910, 920 and 930 is formed on the encapsulation layer 710 and 720. Especially, the color filter layer 910, 920 and 930 is formed on an upper surface of the second encapsulation layer 720. The color filter layer 910, 920 and 930 may include a first color filter layer910 provided in the first sub pixel (P1), a second color filter layer920 provided in the second sub pixel (P2), and a third color filter layer 930 provided in the third sub pixel (P3).

The first color filter layer 910 is overlapped with the first semi-transmissive layer 810, the second color filter layer 920 is overlapped with the second semi-transmissive layer 820, and the third color filter layer 930 is overlapped with the third semi-transmissive layer 830. The first color filter layer 910 is formed of a red (R) color filter layer, the second color filter layer 920 is formed of a green (G) color filter layer, and the third color filter layer 930 is formed of a blue (B) color filter layer.

FIG. 2 is a schematic cross sectional view illustrating an electroluminescent display device according to another embodiment not forming part of the claimed invention. Except a structure of a semi-transmissive layer 810, 820 and 830 and an encapsulation layer 710, 720, 730 and 740, the electroluminescent display device of FIG. 2 is identical to the electroluminescent display device of FIG. 1. Accordingly, the same reference numbers will be used throughout the drawings to refer to the same or like parts, and only the different structures will be described as follows.

As shown in FIG. 2, the encapsulation layer 710, 720, 730 and 740 includes a first encapsulation layer 710 formed on a second electrode 600, a second encapsulation layer 720 formed on the first encapsulation layer 710, a third encapsulation layer 730 formed on the second encapsulation layer 720, and a fourth encapsulation layer 740 formed on the third encapsulation layer 730.

The semi-transmissive layer 810, 820 and 830 includes a first semi-transmissive layer 810 patterned in a first sub pixel (P1), a second semi-transmissive layer 820 patterned in a second sub pixel (P2), and a third semi-transmissive layer 830 patterned in a third sub pixel (P3).

The first semi-transmissive layer 810 is formed between the third encapsulation layer 730 and the fourth encapsulation layer 740, the second semi-transmissive layer 820 is formed between the second encapsulation layer 720 and the third encapsulation layer 730, and the third semi-transmissive layer 830 is formed between the first encapsulation layer 710 and the second encapsulation layer 720.

Accordingly, in the area overlapped with the first semi-transmissive layer 810, an upper surface of the first encapsulation layer 710 is in contact with a lower surface of the second encapsulation layer 720, an upper surface of the second encapsulation layer 720 is in contact with a lower surface of the third encapsulation layer 730, an upper surface of the third encapsulation layer 730 is in contact with a lower surface of the first semi-transmissive layer 810, and a lower surface of the fourth encapsulation layer 740 is in contact with an upper surface of the first semi-transmissive layer 810.

Also, in the area overlapped with the second semi-transmissive layer 820, an upper surface of the first encapsulation layer 710 is in contact with a lower surface of the second encapsulation layer 720, an upper surface of the second encapsulation layer 720 is in contact with a lower surface of the first semi-transmissive layer 810, a lower surface of the third encapsulation layer 730 is in contact with an upper surface of the first semi-transmissive layer 810, and an upper surface of the third encapsulation layer 730 is in contact with a lower surface of the fourth encapsulation layer 740.

Also, in the area overlapped with the third semi-transmissive layer 830, an upper surface of the first encapsulation layer 710 is in contact with a lower surface of the first semi-transmissive layer 810, a lower surface of the second encapsulation layer 720 is in contact with an upper surface of the first semi-transmissive layer 810, an upper surface of the second encapsulation layer 720 is in contact with a lower surface of the third encapsulation layer 730, and an upper surface of the third encapsulation layer 730 is in contact with a lower surface of the fourth encapsulation layer 740.

Also, in the area which is not overlapped with the semi-transmissive layer 810, 820 and 830, an upper surface of the first encapsulation layer 710 is in contact with a lower surface of the second encapsulation layer 720, an upper surface of the second encapsulation layer 720 is in contact with a lower surface of the third encapsulation layer 730, and an upper surface of the third encapsulation layer 730 is in contact with a lower surface of the fourth encapsulation layer 740.

Thus, according to another embodiment of the present disclosure, the first semi-transmissive layer 810, the second semi-transmissive layer 820, and the third semi-transmissive layer 830 are formed in the different layers, and thus, are positioned at the different heights, whereby a first distance (D1) between the first semi-transmissive layer 810 and the first reflective electrode 311, a second distance (D2) between the second semi-transmissive layer 820 and the second reflective electrode 321, and a third distance (D3) between the third semi-transmissive layer 830 and the third reflective electrode 331 are different from one another. Accordingly, it is possible to realize the micro-cavity effect by each individual sub pixel (P1, P2, P3).

In detail, when the reflection and re-reflection of the light is repeated between the semi-transmissive layer 810, 820 and 830 and the reflective electrode 311, 321 and 331, if a distance between the semi-transmissive layer 810, 820 and 830 and the reflective electrode 311, 321 and 331 becomes an integer multiple of half-wavelength (λ/2) of light with a predetermined wavelength, a constructive interference occurs, to thereby improve an external extraction efficiency of light. Thus, in order to improve the external extraction efficiency of the light with a predetermined wavelength, the distance between the semi-transmissive layer 810, 820 and 830 and the reflective electrode 311, 321 and 331 has to be differently set by each individual sub pixel (P1, P2, P3) so that the distance between the semi-transmissive layer 810, 820 and 830 and the reflective electrode 311, 321 and 331 becomes the integer multiple of half-wavelength (λ/2) of light with a predetermined wavelength.

According to another embodiment of the present disclosure, the first semi-transmissive layer 810, the second semi-transmissive layer 820, and the third semi-transmissive layer 830 are positioned at the different heights, whereby the first distance (D1) between the first semi-transmissive layer 810 and the first reflective electrode 311, the second distance (D2) between the second semi-transmissive layer 820 and the second reflective electrode 321, and the third distance (D3) between the third semi-transmissive layer 830 and the third reflective electrode 331 are different from one another. In this case, the thickness of the first encapsulation layer 710, the thickness of the second encapsulation layer 720, and the thickness of the third encapsulation layer 730 are set appropriately so that the first distance (D1), the second distance (D2), and the third distance (D3) are set to be the integer multiple of half-wavelength (λ/2) of light by each sub pixel (P1, P2, P3).

For example, the first distance (D1) between the first semi-transmissive layer 810 and the first reflective electrode 311 is the largest in the first sub pixel (P1) configured to emit red (R) colored light with a long wavelength, and the third distance (D3) between the third semi-transmissive layer 830 and the third reflective electrode 331 is the smallest in the third sub pixel (P3) configured to emit blue (B) colored light with a short wavelength. However, because the integer multiple of half-wavelength (λ/2) of light with a predetermined wavelength may be changed to be once, double, or triple by each sub pixel (P1, P2, P3), it is unnecessary to make the first distance (D1) be the largest in the first sub pixel (P1) for emitting the red (R) colored light with the long wavelength.

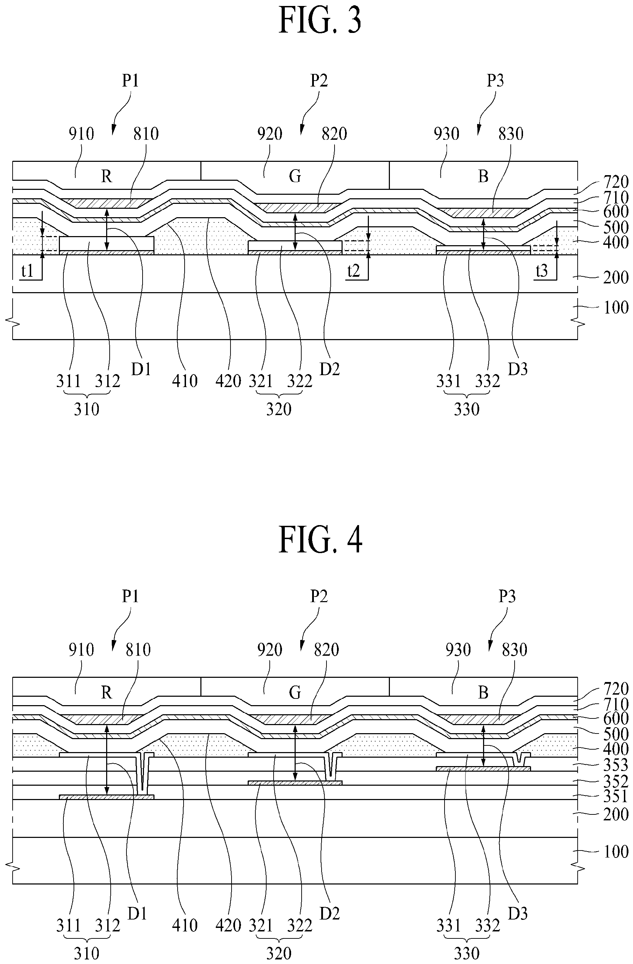

FIG. 3 is a schematic cross sectional view illustrating an electroluminescent display device according to another embodiment not forming part of the claimed invention. Except a structure of a reflective electrode 311, 321 and 331, the electroluminescent display device of FIG. 3 is identical to the electroluminescent display device of FIG. 1. Accordingly, the same reference numbers will be used throughout the drawings to refer to the same or like parts, and only the different structures will be described as follows.

As shown in FIG. 3, a first reflective electrode 311 has a first thickness (t1), a second reflective electrode 321 has a second thickness (t2), and a third reflective electrode 331 has a third thickness (t3). In this case, the first thickness (t1), the second thickness (t2), and the third thickness (t3) may be different from one another. For example, the first thickness (t1) is the largest, the second thickness (t2) is middle, and the third thickness (t3) is the smallest.

Accordingly, a first distance (D1) between the first reflective electrode 311 and a first semi-transmissive layer 810, a second distance (D2) between the second reflective electrode 321 and a second semi-transmissive layer 820, and a third distance (D3) between the third reflective electrode 331 and a third semi-transmissive layer 830 may be different from one another, whereby it is possible to obtain a micro-cavity effect by each individual sub pixel (P1, P2, P3), as described in the above FIG. 2.

Meanwhile, although not shown, a structure of semi-transmissive layers 810, 820 and 830 and a structure of encapsulation layers 710 and 720 in the structure of FIG. 3 may be changed to be the same as those of the semi-transmissive layers 810, 820 and 830 and encapsulation layer 710, 720, 730 and 740 in the structure of FIG. 2.

FIG. 4 is a schematic cross sectional view illustrating an electroluminescent display device according to another embodiment not forming part of the claimed invention. Except a structure of a reflective electrode 311, 321 and 331 and a structure of a transparent electrode 312, 322 and 332, the electroluminescent display device of FIG. 4 is identical to the electroluminescent display device of FIG. 1. Accordingly, the same reference numbers will be used throughout the drawings to refer to the same or like parts, and only the different structures will be described as follows.

As shown in FIG. 4, in an area of a first sub pixel (P1), a first reflective electrode 311 is formed on a circuit device layer 200, a first insulating interlayer 351 is formed on the first reflective electrode 311, a second insulating interlayer 352 is formed on the first insulating interlayer 351, a third insulating interlayer 353 is formed on the second insulating interlayer 352, and a first transparent electrode 312 is formed on the third insulating interlayer 353. The first transparent electrode 312 may be electrically connected with the first reflective electrode 311 via a contact hole provided in the first insulating interlayer 351, the second insulating interlayer 352, and the third insulating interlayer 353. However, the first transparent electrode 312 may be directly connected with a source terminal or drain terminal of a driving thin film transistor provided in the circuit device layer 200 without being electrically connected with the first reflective electrode 311.

In an area of a second sub pixel (P2), the first insulating interlayer 351 is formed on the circuit device layer 200, a second reflective electrode 321 is formed on the first insulating interlayer 351, the second insulating interlayer 352 is formed on the second reflective electrode 321, the third insulating interlayer 353 is formed on the second insulating interlayer 352, and a second transparent electrode 322 is formed on the third insulating interlayer 353. The second transparent electrode 322 may be electrically connected with the second reflective electrode 321 via a contact hole provided in the second insulating interlayer 352 and the third insulating interlayer 353. However, the second transparent electrode 322 may be directly connected with the source terminal or drain terminal of the driving thin film transistor provided in the circuit device layer 200 without being electrically connected with the second reflective electrode 321.

In an area of a third sub pixel (P3), the first insulating interlayer 351 is formed on the circuit device layer 200, the second insulating interlayer 352 is formed on the first insulating interlayer 351, a third reflective electrode 331 is formed on the second insulating interlayer 352, the third insulating interlayer 353 is formed on the third reflective electrode 311, and a third transparent electrode 332 is formed on the third insulating interlayer 353. The third transparent electrode 332 may be electrically connected with the third reflective electrode 331 via a contact hole provided in the third insulating interlayer 353. However, the third transparent electrode 332 may be directly connected with the source terminal or drain terminal of the driving thin film transistor provided in the circuit device layer 200 without being electrically connected with the third reflective electrode 331.

Thus, according to another embodiment of the present disclosure, the first reflective electrode 311, the second reflective electrode 321, and the third reflective electrode 331 are formed in the different layers, and thus, are positioned at the different heights so that a first distance (D1) between the first reflective electrode 311 and a first semi-transmissive layer 810, a second distance (D2) between the second reflective electrode 321 and a second semi-transmissive layer 820, and a third distance (D3) between the third reflective electrode 331 and a third semi-transmissive layer 830 may be different from one another, whereby it is possible to obtain a micro-cavity effect by each individual sub pixel (P1, P2, P3).

Meanwhile, although not shown, a structure of semi-transmissive layers 810, 820 and 830 and a structure of encapsulation layers 710 and 720 in the structure of FIG. 4 may be changed to be the same as those of the semi-transmissive layers 810, 820 and 830 and encapsulation layer 710, 720, 730 and 740 in the structure of FIG. 2.

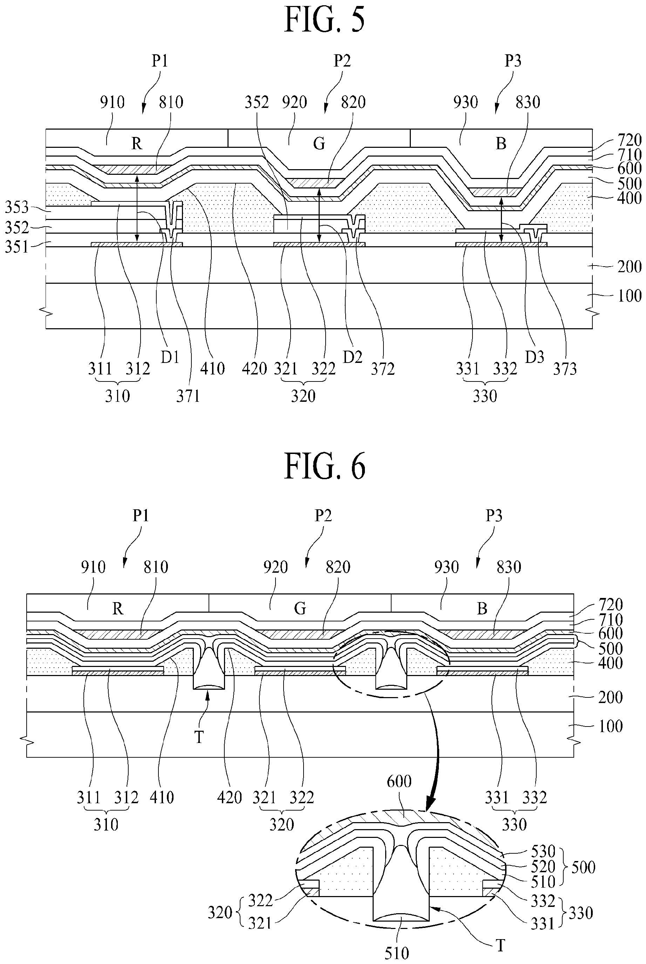

FIG. 5 is a schematic cross sectional view illustrating an electroluminescent display device according to another embodiment not forming part of the claimed invention. Except a structure of a reflective electrode 311, 321 and 331 and a structure of a transparent electrode 312, 322 and 332, the electroluminescent display device of FIG. 5 is identical to the electroluminescent display device of FIG. 1. Accordingly, the same reference numbers will be used throughout the drawings to refer to the same or like parts, and only the different structures will be described as follows.

As shown in FIG. 5, in an area of a first sub pixel (P1), a first reflective electrode 311 is formed on a circuit device layer 200, a first insulating interlayer 351 is formed on the first reflective electrode 311, a first connection electrode 371 is formed on the first insulating interlayer 351, a second insulating interlayer 352 is formed on the first connection electrode 371, a third insulating interlayer 353 is formed on the second insulating interlayer 352, and a first transparent electrode 312 is formed on the third insulating interlayer 353. The first connection electrode 371 may be electrically connected with the first reflective electrode 311 via a contact hole provided in the first insulating interlayer 351, and the first transparent electrode 312 is connected with the first connection electrode 371 via a contact hole provided in the second insulating interlayer 352 and the third insulating interlayer 353. However, the first transparent electrode 312 may be directly connected with a source terminal or drain terminal of a driving thin film transistor provided in the circuit device layer 200 without being electrically connected with the first reflective electrode 311 through the first connection electrode 371. In this case, the first connection electrode 371 is omitted.

In an area of a second sub pixel (P2), a second reflective electrode 321 is formed on the circuit device layer 200, the first insulating interlayer 351 is formed on the second reflective electrode 321, a second connection electrode 372 is formed on the first insulating interlayer 351, the second insulating interlayer 352 is formed on the second connection electrode 372, and a second transparent electrode 332 is formed on the second insulating interlayer 352. The second connection electrode 372 is connected with the second reflective electrode 321 via a contact hole provided in the first insulating interlayer 351, and the second transparent electrode 322 is connected with the second connection electrode 372 via a contact hole provided in the second insulating interlayer 352. However, the second transparent electrode 322 may be directly connected with the source terminal or drain terminal of the driving thin film transistor provided in the circuit device layer 200 without being electrically connected with the second reflective electrode 321 through the second connection electrode 372. In this case, the second connection electrode 372 is omitted.

In an area of a third sub pixel (P3), a third reflective electrode 331 is formed on the circuit device layer 200, the first insulating interlayer 351 is formed on the third reflective electrode 331, a third connection electrode 373 is formed on the first insulating interlayer 351, and a third transparent electrode 332 is formed on the third connection electrode 373. The third connection electrode 373 is connected with the third reflective electrode 331 via a contact hole provided in the first insulating interlayer 351, and the third transparent electrode 332 is directly formed on an upper surface of the third connection electrode 373. However, the third transparent electrode 332 may be directly connected with the third reflective electrode 331 via a contact hole provided in the first insulating interlayer 351. In this case, the third connection electrode 373 may be omitted. Also, the third transparent electrode 332 may be directly connected with the source terminal or drain terminal of the driving thin film transistor provided in the circuit device layer 200 without being electrically connected with the third reflective electrode 331. In this case, the third connection electrode 373 is omitted.

The second insulating interlayer 352 provided in the first sub pixel (P1) and the second insulating interlayer 352 provided in the second sub pixel (P2) are spaced from each other, and a bank 400 may be provided in the spaced space between the second insulating interlayer 352 provided in the first sub pixel (P1) and the second insulating interlayer 352 provided in the second sub pixel (P2). The second insulating interlayer 352 may be not provided in the third sub pixel (P3). Also, the third insulating interlayer 353 may be not provided in the second sub pixel (P2) and the third sub pixel (P3).

Thus, according to another embodiment of the present disclosure, the first transparent electrode 312, the second transparent electrode 322, and the third transparent electrode 332 are formed in the different layers, and thus, are positioned at the different heights so that a first distance (D1) between the first reflective electrode 311 and a first semi-transmissive layer 810, a second distance (D2) between the second reflective electrode 321 and a second semi-transmissive layer 820, and a third distance (D3) between the third reflective electrode 331 and a third semi-transmissive layer 830 may be different from one another, whereby it is possible to obtain a micro-cavity effect by each individual sub pixel (P1, P2, P3) with easiness.

Meanwhile, although not shown, a structure of semi-transmissive layers 810, 820 and 830 and a structure of encapsulation layers 710 and 720 in the structure of FIG. 5 may be changed to be the same as those of the semi-transmissive layers 810, 820 and 830 and encapsulation layer 710, 720, 730 and 740 in the structure of FIG. 2.

FIG. 6 is a schematic cross sectional view illustrating an electroluminescent display device according to another embodiment of the present disclosure. A trench (T) is additionally provided in the boundary between sub pixels (P1, P2, P3) of the electroluminescent display device shown in FIG. 6, whereby the electroluminescent display device shown in FIG. 6 is different from the electroluminescent display device shown in FIG. 1. Accordingly, the same reference numbers will be used throughout the drawings to refer to the same or like parts, and only the different structures will be described as follows.

As shown in FIG. 6, a trench (T) is provided in the boundary between sub pixels (P1, P2, P3). The trench (T) may be provided in a bank 400 and a circuit device layer 200. That is, the trench (T) may be provided in some areas of an upper portion of the circuit device layer 200, for example, a planarization layer while passing through the bank 400. However, it is not limited to this structure. The trench (T) may be provided in some areas of an upper portion of the bank 400 without passing through the bank 400.

The trench (T) is provided in the boundary between sub pixels (P1, P2, P3), and an emission layer 500 is formed in the trench (T), a long current path is formed between the neighboring sub pixels (P1, P2, P3), to thereby reduce a leakage current from being generated between the neighboring sub pixels (P1, P2, P3). That is, on the assumption that an interval between the sub pixels (P1, P2, P3) becomes compact in order to realize a high resolution, if the emission layer 500 inside any one of the sub pixels (P1, P2, P3) emits light, charges of the corresponding emission layer 500 may be transferred to another emission layer 500 of neighboring another sub pixel (P1, P2, P3), whereby there is a possibility of leakage current.

Thus, according to embodiments of the present disclosure, the trench (T) is formed in the boundary between the sub pixels (P1, P2, P3), and the emission layer 500 is formed in the trench (T) so that a resistance is increased due to the long current path formed between the neighboring sub pixels (P1, P2, P3), to thereby reduce an occurrence of a leakage current.

Especially, the emission layer 500 includes a first stack 510, a second stack 530, and a charge generating layer 520 disposed between the first stack 510 and the second stack 530.

The first stack 510 is formed on an inner lateral surface of the trench (T), and is formed on an inner lower surface of the trench (T). Some area of the first stack 510 formed on the inner lateral surface of the trench (T) is disconnected from some area of the first stack 510 formed on the inner lower surface of the trench (T). Thus, some area of the first stack formed on one lateral surface inside the trench (T), and more particularly, on the left lateral surface inside the trench (T) is not connected with some area of the first stack formed on the other lateral surface inside the trench (T), and more particularly, on the right lateral surface inside the trench (T). Accordingly, charges are not transferred between the sub pixels (P1, P2, P3) arranged with the trench (T) interposed in-between through the first stack 510.

Also, the charge generating layer 520 may be formed on the first stack 510 at the inner lateral surface of trench (T). In this case, some area of the charge generating layer 520 formed on one inner lateral surface of the trench (T), and more particularly, on the left lateral surface inside the trench (T) is not connected with some area of the charge generating layer 520 formed on the other inner lateral surface of the trench (T), and more particularly, on the right lateral surface inside the trench (T). Accordingly, charges are not transferred between the sub pixels (P1, P2, P3) arranged with the trench (T) interposed in-between through the charge generating layer520.

Also, the second stack 530 is provided connectedly between the neighboring sub pixels (P1, P2, P3) with the trench (T) interposed in-between on the charge generating layer 520. Thus, charges are transferred between the sub pixels (P1, P2, P3) with the trench (T) interposed in-between through the second stack 530.

Conductivity of the charge generating layer 520 is higher than that of each of the first stack 510 and the second stack 530. Especially, an N-type charge generating layer of the charge generating layer 520 may comprise a metal material, whereby conductivity of the charge generating layer 520 is higher than that of each of the first stack 510and the second stack 530. Thus, the charge transfer between the sub pixels (P1, P2, P3) which are adjacent to each other is generally made through the charge generating layer 520, and the charge transfer through the second stack 530 is insignificant.

Thus, according to another embodiment of the present disclosure, when the emission layer 500 is formed inside the trench (T), some of the emission layer 500 is disconnectedly provided, especially, the first stack 510 and the charge generating layer 520 are provided disconnectedly so that it is possible to reduce the charge transfer between the sub pixels (P1, P2, P3) which are disposed while being adjacent to each other, to thereby prevent a leakage current.

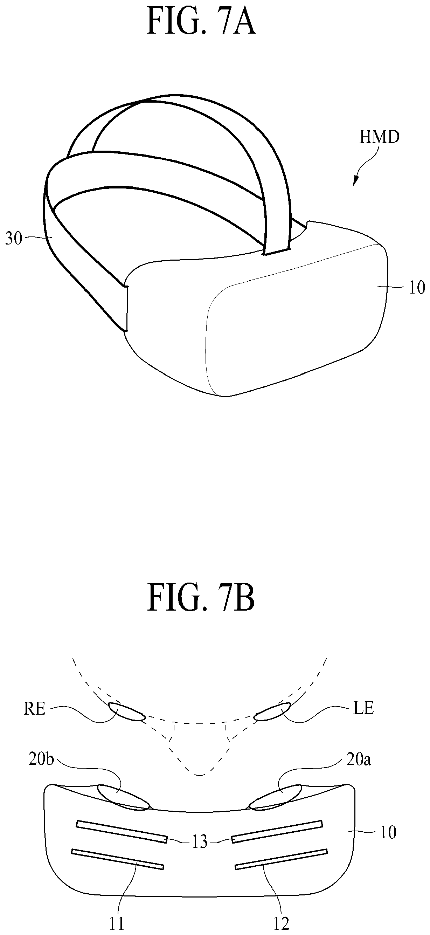

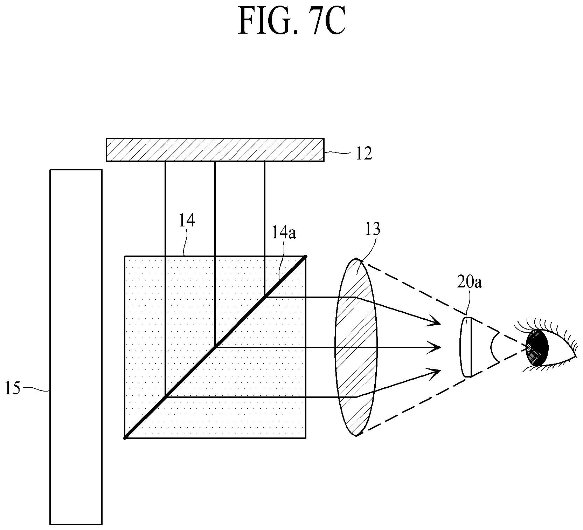

FIGs. 7A to 7C illustrate an electroluminescent display device according to another embodiment of the present disclosure, which relate with a head mounted display (HMD) device. FIG. 7A is a schematic perspective view, FIG. 7B is a schematic plane view of a virtual reality (VR) structure, and FIG. 7C is a schematic cross sectional view of an augmented reality (AR) structure.

As shown in FIG. 7A, the head mounted display (HMD) device according to the present disclosure includes a receiving case 10 and a head mounted band 30.

A display device, a lens array and an ocular eyepiece may be received in the inside of the receiving case 10.

The head mounted band 30 is fixed to the receiving case 10. In the drawings, the head mounted band 30 is configured to surround an upper surface and both lateral surfaces in a user's head, but not limited to this structure. For example, the head mounted band is provided to fix the head mounted display (HMD) device to a user's head, which may be substituted by an eyeglass-frame shape or a helmet-shaped structure.

As shown in FIG. 7B, the head mounted display (HMD) device of the virtual reality (VR) structure according to the present disclosure includes a left-eye display device 12, a right-eye display device 11, a lens array 13, a left-eye ocular eyepiece 20a and a right-eye ocular eyepiece 20b.

The left-eye display device 12, the right-eye display device 11, the lens array 13, and the left-eye ocular eyepiece 20a and the right-eye ocular eyepiece 20b are received in the aforementioned receiving case 10.

The same image may be displayed on the left-eye display device 12 and the right-eye display device 11. In this case, a user can watch a two-dimensional (2D) image. If an image for a left eye is displayed on the left-eye display device 12, and an image for a right eye is displayed on the right-eye display device 11, a user can watch a three-dimensional (3D) image. Each of the left-eye display device 12 and the right-eye display device 11 may be formed of the aforementioned display device according to the embodiments of the present disclosure. In this case, an upper portion corresponding to a surface for displaying an image in the aforementioned display device according to the embodiments of the present disclosure, for example, the color filter layer 910, 920 and 930 confronts the lens array 13.

The lens array 13 may be disposed between the left-eye ocular eyepiece 20a and the left-eye display device 12 while being apart from each of the left-eye ocular eyepiece 20a and the left-eye display device 12. That is, the lens array 13 may be positioned at the front of the left-eye ocular eyepiece 20a and at the rear of the left-eye display device 12. Also, the lens array 13 may be disposed between the right-eye ocular eyepiece 20b and the right-eye display device 11 while being apart from each of the right-eye ocular eyepiece 20b and the right-eye display device 11. That is, the lens array 13 may be positioned at the front of the right-eye ocular eyepiece 20b and at the rear of the right-eye display device 11.

The lens array 13 may be a micro lens array. The lens array 13 may be substituted by a pin hole array. Owing to the lens array 13, an image displayed on the left-eye display device 12 or the right-eye display device 11 may be expanded and perceived by a user.

A user's left eye (LE) may be positioned at the left-eye ocular eyepiece 20a, and a user's right eye (RE) may be positioned at the right-eye ocular eyepiece 20b.

As shown in FIG. 7C, the head mounted display (HMD) device of the augmented reality (AR) structure according to the present disclosure includes a left-eye display device 12, a lens array 13, a left-eye ocular eyepiece 20a, a transmissive reflecting portion 14 and a transmission window 15. FIG. 7C shows only the left-eye structure, for convenience of explanation. The right-eye structure is identical in structure to the left-eye structure.

The left-eye display device 12, the lens array 13, the left-eye ocular eyepiece 20a, the transmissive reflecting portion 14 and the transmission window 15 are received in the aforementioned receiving case 10.

The left-eye display device 12 may be disposed at one side of the transmissive reflecting portion 14, for example, an upper side of the transmissive reflecting portion 14 without covering the transmission window 15. Accordingly, an image may be provided to the transmissive reflecting portion 14 under the condition that an ambient background seen through the transmission window 15 is not covered by the left-eye display device 12.

The left-eye display device 12 may be formed of the aforementioned various electroluminescent display devices according to the embodiments of the present disclosure. In this case, an upper portion corresponding to a surface for displaying an image in the aforementioned various electroluminescent display devices according to the embodiments of the present disclosure, for example, the color filter layer 910, 920 and 930 confronts the transmissive reflecting portion 14.

The lens array 13 may be provided between the left-eye ocular eyepiece 20a and the transmissive reflecting portion 14.

A user's left eye is positioned at the left-eye ocular eyepiece 20a.

The transmissive reflecting portion 14 is disposed between the lens array 13 and the transmission window 15. The transmissive reflecting portion 14 may include a reflection surface 14a which partially transmits some of light, and also reflects the remaining light. The reflection surface 14a is configured to guide an image, which is displayed on the left-eye display device 12, toward the lens array 13. Thus, a user can watch an image displayed on the left-eye display device 12 together with the ambient background through the transmission window 15. That is, a user can watch one image obtained by a virtual image overlaid with the ambient real background, to thereby realize an augmented reality (AR).

The transmission window 15 is disposed in front of the transmissive reflecting portion 14.

In the above embodiments of the present disclosure, the emission layer 500 is configured to emit white colored light, but not necessarily. The emission layer 500 may be configured to emit different colored light by each sub pixel (P1, P2, P3).

It will be apparent to those skilled in the art that various modifications and variations can be made in the present disclosure without departing from the scope of the appended claims. Thus, it is intended that the present disclosure covers the modifications and variations of this disclosure provided they come within the scope of the appended claims.

## Claims

1. An electroluminescent display device comprising:
a substrate including a first sub pixel (P1), a second sub pixel (P2), and a third sub pixel (P3) disposed thereon;
a first electrode (310, 320, 330) in each of the first to third sub pixels on the substrate;
an emission layer (500) on the first electrode, wherein the emission layer comprising a first stack, a second stack, and a charge generating layer disposed between the first stack and the second stack, wherein the second stack is provided connectedly between neighboring sub pixels;
a second electrode (600) on the emission layer;
an encapsulation layer (710, 720) including a first encapsulation layer (710) provided on the second electrode, and a second encapsulation layer (720) provided on the first encapsulation layer;
a first semi-transmissive layer (810) provided between the first encapsulation layer and the second encapsulation layer and overlapped with the first electrode of the first sub pixel, and
a bank (400) provided in the boundary area between each of the first sub pixel, the second sub pixel, and the third sub pixel,
wherein a trench (T) is provided inside the bank,
the first stack (510) is disposed on an inner lateral surface of the trench (T) and on an inner lower surface of the trench (T), and some area of the first stack (510) on an inner lateral surface of the trench is disconnected from some area of the first stack on an inner lower surface of the trench.

2. The electroluminescent display device according to claim 1, wherein the first electrode (310) of the first sub pixel (P1) includes a first reflective electrode (311), and the second electrode (600) includes a transparent electrode optionally wherein the first electrode (310) of the first subpixel (P1) includes a first transparent electrode (312) on the first reflective electrode (311).

3. The electroluminescent display device according to claim 2, wherein the first reflective electrode and the first semi-transmissive layer are configured such that light emitted from the emission layer is repetitively reflected and re-reflected between the first reflective electrode and the first semi-transmissive layer.

4. The electroluminescent display device according to claim 1, 2 and 3, wherein the first encapsulation layer and the second encapsulation layer are in contact with each other in the boundary area between the first sub pixel and the second sub pixel.

5. The electroluminescent display device according to any preceding claim, wherein the first semi-transmissive layer is not provided in the area which is overlapped with an upper surface of the bank.

6. The electroluminescent display device according to any preceding claim, wherein a lateral surface of the bank is inclined in such a way that an angle between the lateral surface of the bank and an upper surface of the substrate is within a range of 30° to 80°.

7. The electroluminescent display device according to any preceding claim, wherein a reflective layer is additionally provided in a lateral surface of the bank.

8. The electroluminescent display device according to any preceding claim, furth er comprising a lens array (13) spaced apart from the substrate, and a receiving case for re ceiving the substrate and the lens array therein.

9. The electroluminescent display device according to any preceding claim, further comprising a second semi-transmissive layer (820) overlapped with the first electrode of the second sub pixel and provided on the second electrode, and a third semi-transmissive layer (830) overlapped with the first electrode of the third sub pixel and provided on the second electrode.

10. The electroluminescent display device according to claim 9, wherein the second semi-transmissive layer and the third semi-transmissive layer are provided between the first encapsulation layer and the second encapsulation layer, or wherein the second semi-transmissive layer and the third semi-transmissive layer are each provided at a different position from that of the first semi-transmissive layer.

11. The electroluminescent display device according to any of claims 8 or 9,
wherein the first electrode of the first sub pixel includes a first reflective electrode, the first electrode of the second sub pixel includes a second reflective electrode (321), and the first electrode of the third sub pixel includes a third reflective electrode (331), and
a first distance between the first reflective electrode and the first semi-transmissive layer, a second distance between the second reflective electrode and the second semi-transmissive layer, and a third distance between the third reflective electrode and the third semi-transmissive layer are different from one another,
optionally wherein the first reflective electrode, the second reflective electrode, and the third reflective electrode are provided in different layers from one another.

12. The electroluminescent display device according to claim 11,
wherein the first electrode of the first sub pixel additionally includes a first transparent electrode provided on the first reflective electrode, the first electrode of the second sub pixel additionally includes a second transparent electrode (322) provided on the second reflective electrode, and the first electrode of the third sub pixel additionally includes a third transparent electrode (332) provided on the third reflective electrode, and
a thickness of the first transparent electrode, a thickness of the second transparent electrode, and a thickness of the third transparent electrode are different from one another.

13. The electroluminescent display device according to claim 11 or 12,
wherein the first electrode of the first sub pixel additionally includes a first transparent electrode provided on the first reflective electrode, the first electrode of the second sub pixel additionally includes a second transparent electrode provided on the second reflective electrode, and the first electrode of the third sub pixel additionally includes a third transparent electrode provided on the third reflective electrode, and
the first transparent electrode, the second transparent electrode, and the third transparent electrode are provided in different layers from one another.

14. The electroluminescent display device according to any of claims 8-13,
wherein the encapsulation layer further includes a third encapsulation layer (730) provided on the second encapsulation layer, and a fourth encapsulation layer (740) provided on the third encapsulation layer,
the second semi-transmissive layer is provided between the second encapsulation layer and the third encapsulation layer, and
the third semi-transmissive layer is provided between the third encapsulation layer and the fourth encapsulation layer.

## Patentansprüche

1. Elektrolumineszenz-Anzeigevorrichtung, umfassend:
ein Substrat, das ein erste Subpixel (P1), ein zweites Subpixel (P2) und ein drittes Subpixel (P3) darauf angeordnet aufweist;
eine erste Elektrode (310, 320, 330) in jedem des ersten bis dritten Subpixels auf dem Substrat;
eine Emissionsschicht (500) auf der ersten Elektrode, wobei die Emissionsschicht einen ersten Stapel, einen zweiten Stapel und eine Ladungserzeugungsschicht umfasst, die zwischen dem ersten Stapel und dem zweiten Stapel angeordnet ist, wobei der zweite Stapel verbunden zwischen benachbarten Subpixeln vorgesehen ist;
eine zweite Elektrode (600) auf der Emissionsschicht;
eine Verkapselungsschicht (710, 720), die eine erste Verkapselungsschicht (710), die auf der zweiten Elektrode vorgesehen ist, und eine zweite Verkapselungsschicht (720) aufweist, die auf der ersten Verkapselungsschicht vorgesehen ist;
eine halbdurchlässige Schicht (810), die zwischen der ersten Verkapselungsschicht und der zweiten Verkapselungsschicht vorgesehen und von der ersten Elektrode des ersten Subpixels überlappt ist, und
einen Damm (400), der im Grenzbereich zwischen jedem von dem ersten Subpixel, dem zweiten Subpixel und dem dritten Subpixel vorgesehen ist,
wobei ein Graben (T) innerhalb des Damms vorgesehen ist, der erste Stapel (510) auf einer inneren Seitenfläche des Grabens (T) und auf einer inneren Unterseite des Grabens (T) angeordnet ist, und ein Bereich des ersten Stapels (510) auf einer inneren Seitenfläche des Grabens von einem Bereich des ersten Stapels auf der inneren Unterseite des Grabens getrennt ist.

2. Elektrolumineszenz-Anzeigevorrichtung nach Anspruch 1, wobei die erste Elektrode (310) des ersten Subpixels (P1) eine reflektierende Elektrode (311) aufweist und die zweite Elektrode (600) eine durchlässige Elektrode aufweist, wobei optional die erste Elektrode (310) des ersten Subpixels (P1) eine erste durchlässige Elektrode (312) auf der ersten reflektierenden Elektrode (311) aufweist.

3. Elektrolumineszenz-Anzeigevorrichtung nach Anspruch 2, wobei die erste reflektierende Elektrode und die erste halbdurchlässige Schicht so ausgelegt sind, dass Licht, das von der Emissionsschicht emittiert wird, zwischen der ersten reflektierenden Elektrode und der ersten halbdurchlässigen Elektrode wiederholt reflektiert und zurückreflektiert wird.

4. Elektrolumineszenz-Anzeigevorrichtung nach Anspruch 1, 2 und 3, wobei die erste Verkapselungsschicht und die zweite Verkapselungsschicht im Grenzbereich zwischen dem ersten Subpixel und dem zweiten Subpixel miteinander in Kontakt sind.

5. Elektrolumineszenz-Anzeigevorrichtung nach einem der vorhergehenden Ansprüche, wobei die erste halbdurchlässige Schicht nicht in dem Bereich vorgesehen ist, der von einer Oberseite des Damms überlappt ist.

6. Elektrolumineszenz-Anzeigevorrichtung nach einem der vorhergehenden Ansprüche, wobei eine Seitenfläche des Damms derart geneigt ist, dass ein Winkel zwischen der Seitenfläche des Damms und einer Oberseite des Substrats innerhalb eines Bereichs von 30° bis 80° liegt.

7. Elektrolumineszenz-Anzeigevorrichtung nach einem der vorhergehenden Ansprüche, wobei eine reflektierende Schicht in einer Seitenfläche des Damms vorgesehen ist.

8. Elektrolumineszenz-Anzeigevorrichtung nach einem der vorhergehenden Ansprüche, ferner umfassend eine Linsenanordnung (13), die von dem Substrat beabstandet ist, und ein Aufnahmegehäuse zum Aufnehmen des Substrats und der Linsenanordnung darin.

9. Elektrolumineszenz-Anzeigevorrichtung nach einem der vorhergehenden Ansprüche, ferner umfassend eine zweite halbdurchlässige Schicht (820), die von der ersten Elektrode des zweiten Subpixels überlappt und auf der zweiten Elektrode vorgesehen ist, und eine dritte halbdurchlässige Schicht (830), die von der ersten Elektrode des dritten Subpixels überlappt und auf der zweiten Elektrode vorgesehen ist.

10. Elektrolumineszenz-Anzeigevorrichtung nach Anspruch 9, wobei die zweite halbdurchlässige Schicht und die dritte halbdurchlässige Schicht zwischen der erste Verkapselungsschicht und der zweiten Verkapselungsschicht vorgesehen sind, oder wobei die zweite halbdurchlässige Schicht und die dritte halbdurchlässige Schicht jeweils in einer Position vorgesehen sind, die von der der ersten halbdurchlässigen Schicht verschieden ist.

11. Elektrolumineszenz-Anzeigevorrichtung nach einem der vorhergehenden Ansprüche 8 oder 9, wobei die erste Elektrode des ersten Subpixels eine erste reflektierende Elektrode aufweist, die erste Elektrode des zweiten Subpixels eine zweite reflektierende Elektrode (321) aufweist und die erste Elektrode des dritten Subpixels eine dritte reflektierende Elektrode (331) aufweist, und ein erster Abstand zwischen der ersten reflektierenden Elektrode und der ersten halbdurchlässigen Schicht, ein zweiter Abstand zwischen der zweiten reflektierenden Elektrode und der zweiten halbdurchlässigen Schicht und ein dritter Abstand zwischen der dritten reflektierenden Elektrode und der dritten halbdurchlässigen Schicht sich voneinander unterscheiden,
wobei optional die erste reflektierende Elektrode, die zweite reflektierende Elektrode und die dritte reflektierende Elektrode in verschiedenen Schichten voneinander vorgesehen sind.

12. Elektrolumineszenz-Anzeigevorrichtung nach Anspruch 11,
wobei die erste Elektrode des ersten Subpixels zusätzlich eine erste durchlässige Elektrode aufweist, die auf der ersten reflektierenden Elektrode vorgesehen ist, die erste Elektrode des zweiten Subpixels zusätzlich eine zweite durchlässige Elektrode (322) aufweist, die auf der zweiten reflektierenden Elektrode vorgesehen ist, und die erste Elektrode des dritten Subpixels zusätzlich eine dritte durchlässige Elektrode (332) aufweist, die auf der dritten reflektierenden Elektrode vorgesehen ist, und
eine Dicke der ersten durchlässigen Elektrode, eine Dicke der zweiten durchlässigen Elektrode und eine Dicke der dritten durchlässigen Elektrode sich voneinander unterscheiden.

13. Elektrolumineszenz-Anzeigevorrichtung nach Anspruch 11 oder 12,
wobei die erste Elektrode des ersten Subpixels zusätzlich eine erste durchlässige Elektrode aufweist, die auf der ersten reflektierenden Elektrode vorgesehen ist, die erste Elektrode des zweiten Subpixels zusätzlich eine zweite durchlässige Elektrode aufweist, die auf der zweiten reflektierenden Elektrode vorgesehen ist, und die erste Elektrode des dritten Subpixels zusätzlich eine dritte durchlässige Elektrode aufweist, die auf der dritten reflektierenden Elektrode vorgesehen ist, und
die erste durchlässige Elektrode, die zweite durchlässige Elektrode und die dritte durchlässige Elektrode in verschiedenen Schichten voneinander vorgesehen sind.

14. Elektrolumineszenz-Anzeigevorrichtung nach einem der Ansprüche 8 bis 13,
wobei die Verkapselungsschicht (710, 720) ferner eine dritte Verkapselungsschicht (710), die auf der zweiten Verkapselungsschicht vorgesehen ist, und eine vierte Verkapselungsschicht (720) aufweist, die auf der dritten Verkapselungsschicht vorgesehen ist,
die zweite halbdurchlässige Schicht zwischen der zweiten Verkapselungsschicht und der dritten Verkapselungsschicht vorgesehen ist, und
die dritte halbdurchlässige Schicht zwischen der dritten Verkapselungsschicht und der vierten Verkapselungsschicht vorgesehen ist.

## Revendications

1. Dispositif d'affichage électroluminescent comprenant :
un substrat comportant un premier sous-pixel (P1), un deuxième sous-pixel (P2) et un troisième sous-pixel (P3) disposés sur celui-ci ;
une première électrode (310, 320, 330) dans chacun des premier au troisième sous-pixels sur le substrat ;
une couche d'émission (500) sur la première électrode, la couche d'émission comprenant un premier empilement, un deuxième empilement, et une couche générant des charges disposée entre le premier empilement et le deuxième empilement, le deuxième empilement étant disposé de façon connectée entre sous-pixels voisins ;
une deuxième électrode (600) sur la couche d'émission ;
une couche d'encapsulation (710, 720) comportant une première couche d'encapsulation (710) disposée sur la deuxième électrode, et une deuxième couche d'encapsulation (720) disposée sur la première couche d'encapsulation ;
une première couche semi-transmissive (810) disposée entre la première couche d'encapsulation et la deuxième couche d'encapsulation et chevauchant la première électrode du premier sous-pixel ; et
un talus (400) disposé dans la zone limite entre à la fois le premier sous-pixel, le deuxième sous-pixel et le troisième sous-pixel,
dans lequel une tranchée (T) est disposée à l'intérieur du talus, le premier empilement (510) est disposé sur une surface latérale interne de la tranchée (T) et sur une surface inférieure interne de la tranchée (T), et une certaine zone du premier empilement (510) sur une surface latérale interne de la tranchée est déconnectée d'une certaine zone du premier empilement sur une surface inférieure interne de la tranchée.

2. Dispositif d'affichage électroluminescent selon la revendication 1, dans lequel la première électrode (310) du premier sous-pixel (P1) comporte une première électrode réfléchissante (311), et la deuxième électrode (600) comporte une électrode transparente, éventuellement dans lequel la première électrode (310) du premier sous-pixel (P1) comporte une première électrode transparente (312) sur la première électrode réfléchissante (311).

3. Dispositif d'affichage électroluminescent selon la revendication 2, dans lequel la première électrode réfléchissante et la première couche semi-transmissive sont configurées de telle sorte que la lumière émise depuis la couche d'émission est réfléchie et réfléchie encore de façon répétée entre la première électrode réfléchissante et la première couche semi-transmissive.

4. Dispositif d'affichage électroluminescent selon la revendication 1, 2 ou 3, dans lequel la première couche d'encapsulation et la deuxième couche d'encapsulation sont en contact l'une avec l'autre dans la zone limite entre le premier sous-pixel et le deuxième sous-pixel.

5. Dispositif d'affichage électroluminescent selon une quelconque revendication précédente, dans lequel la première couche semi-transmissive n'est pas disposée dans la zone qui chevauche une surface supérieure du talus.

6. Dispositif d'affichage électroluminescent selon une quelconque revendication précédente, dans lequel une surface latérale du talus est inclinée de telle sorte qu'un angle entre la surface latérale du talus et une surface supérieure du substrat se situe dans une plage de 30° à 80°.

7. Dispositif d'affichage électroluminescent selon une quelconque revendication précédente, dans lequel une couche réfléchissante est également disposée dans une surface latérale du talus.

8. Dispositif d'affichage électroluminescent selon une quelconque revendication précédente, comprenant en outre un réseau de lentilles (13) espacé du substrat, et un boîtier de réception pour y recevoir le substrat et le réseau de lentilles.

9. Dispositif d'affichage électroluminescent selon une quelconque revendication précédente, comprenant en outre une deuxième couche semi-transmissive (820) chevauchant la première électrode du deuxième sous-pixel et disposée sur la deuxième électrode, et une troisième couche semi-transmissive (830) chevauchant la première électrode du troisième sous-pixel et disposée sur la deuxième électrode.

10. Dispositif d'affichage électroluminescent selon la revendication 9, dans lequel la deuxième couche semi-transmissive et la troisième couche semi-transmissive sont disposées entre la première couche d'encapsulation layer et la deuxième couche d'encapsulation, ou dans lequel la deuxième couche semi-transmissive et la troisième couche semi-transmissive sont chacune disposées à une position différente de celle de la première couche semi-transmissive.

11. Dispositif d'affichage électroluminescent selon l'une quelconque des revendications 8 et 9, dans lequel la première électrode du premier sous-pixel comporte une première électrode réfléchissante, la première électrode du deuxième sous-pixel comporte une deuxième électrode réfléchissante (321), et la première électrode du troisième sous-pixel comporte une troisième électrode réfléchissante (331), et
une première distance entre la première électrode réfléchissante et la première couche semi-transmissive, une deuxième distance entre la deuxième électrode réfléchissante et la deuxième couche semi-transmissive, et une troisième distance entre la troisième électrode réfléchissante et la troisième couche semi-transmissive sont différentes les unes des autres,
éventuellement dans lequel la première électrode réfléchissante, la deuxième électrode réfléchissante et la troisième électrode réfléchissante sont disposées dans des couches différentes les unes des autres.

12. Dispositif d'affichage électroluminescent selon la revendication 11,
dans lequel la première électrode du premier sous-pixel comporte également une première électrode transparente disposée sur la première électrode réfléchissante, la première électrode du deuxième sous-pixel comporte également une deuxième électrode transparente (322) disposée sur la deuxième électrode réfléchissante, et la première électrode du troisième sous-pixel comporte également une troisième électrode transparente (332) disposée sur la troisième électrode réfléchissante, et
une épaisseur de la première électrode transparente, une épaisseur de la deuxième électrode transparente et une épaisseur de la troisième électrode transparente sont différentes les unes des autres.

13. Dispositif d'affichage électroluminescent selon la revendication 11 ou 12,
dans lequel la première électrode du premier sous-pixel comporte également une première électrode transparente disposée sur la première électrode réfléchissante, la première électrode du deuxième sous-pixel comporte également une deuxième électrode transparente disposée sur la deuxième électrode réfléchissante, et la première électrode du troisième sous-pixel comporte également une troisième électrode transparente disposée sur la troisième électrode réfléchissante, et
la première électrode transparente, la deuxième électrode transparente et la troisième électrode transparente sont disposées dans des couches différentes les unes des autres.

14. Dispositif d'affichage électroluminescent selon l'une quelconque des revendications 8 à 13,
dans lequel la couche d'encapsulation comporte en outre une troisième couche d'encapsulation (730) disposée sur la deuxième couche d'encapsulation, et une quatrième couche d'encapsulation (740) disposée sur la troisième couche d'encapsulation,
la deuxième couche semi-transmissive est disposée entre la deuxième couche d'encapsulation et la troisième couche d'encapsulation, et
la troisième couche semi-transmissive est disposée entre la troisième couche d'encapsulation et la quatrième couche d'encapsulation.
